# EUROPEAN PATENT APPLICATION

(11) **EP 2 998 967 A1**
(43) Date of publication of application: **23.03.2016**
(21) Application number: 14797696.3
(22) Date of filing: 31.01.2014
(51) Int. Cl.: H01B 1/22, B22F 7/04, B22F 9/00, C09D 5/24, C09D 7/12, H01B 1/02, H01B 5/14, H01B 13/00, H05K 1/09, H05K 3/10

(54) **COPPER-FINE-PARTICLE DISPERSION LIQUID, CONDUCTIVE-FILM FORMATION METHOD, AND CIRCUIT BOARD**

(30) Priority: 15.05.2013 JP 2013102916
(71) Applicant: Ishihara Chemical Co., Ltd., Kobe-shi Hyogo 652-0806 (JP)
(72) Inventor: KAWATO, Yuichi, Kobe-shi Hyogo 652-0806 (JP); ARIMURA, Hidetoshi, Kobe-shi Hyogo 652-0806 (JP); KUDO, Tomio, Kobe-shi Hyogo 652-0806 (JP)
(74) Representative: Hoefer & Partner Patentanwälte mbB
(86) International application number: PCT/JP2014/052222
(87) International publication number: WO 2014/185102

(57) **Abstract**

[Technical Problem]

Provided is a copper particulate dispersion that can facilitate the formation of a conductive film with low electric resistance by photo-sintering.

[Solution to Problem]

A copper particulate dispersion 1 comprises a dispersion vehicle and copper particulates 11 dispersed in the dispersion vehicle. The copper particulate dispersion 1 contains a sintering promoter. The sintering promoter is a compound that removes copper oxide from copper at a temperature higher than ambient temperature. The sintering promoter thereby removes surface oxide coatings from the copper particulates 11 during the photo-sintering of the copper particulates 11.

## Description

### [Technical Field]

The present invention relates to copper particulate dispersion, a conductive film forming method using the copper particulate dispersion, and a circuit board produced by using the conductive film forming method.

### [Background Art]

Conventionally, there is a printed circuit board in which a copper foil circuit is formed on a substrate by photolithography. Photolithography requires a step of etching copper foil, which incurs the cost of, for example, treating wastewater generated by etching.

As a technique without the need of etching, there is a known method for forming a conducting membrane (conductive film) on a substrate using a copper particulate dispersion (copper ink) that contains copper particulates (copper nanoparticles) in a dispersion vehicle (for example, see Patent Literature 1). According to this method, a coating of the copper particulate dispersion is formed on the substrate, and the coating is dried to form a copper particulate layer. The copper particulate layer is photo-sintered by irradiation with light, thereby forming a conductive film with low electric resistance.

However, even when the energy of light irradiated in the photo-sintering is increased in the above-mentioned method, the photo-sintering may not sufficiently proceed, thereby failing to form a conductive film with low electric resistance.

### [Citation List]

### [Patent Literature]

Patent Literature 1: U.S. Patent Application No. US 2008/0286488

### [Summary of Invention]

### [Technical Problem]

The present invention is made to solve the above problem, and an object of the present invention is to provide a copper particulate dispersion that can facilitate the formation of a conductive film with low electric resistance by photo-sintering.

### [Solution to Problem]

The copper particulate dispersion according to the present invention comprises a dispersion vehicle and copper particulates dispersed in the dispersion vehicle. The copper particulate dispersion contains a sintering promoter. The sintering promoter is a compound that removes copper oxide from copper at a temperature higher than ambient temperature.

In the copper particulate dispersion, the temperature higher than ambient temperature is preferably obtained by irradiation with light for photo-sintering the copper particulates.

In the copper particulate dispersion, the sintering promoter is preferably a compound that forms a complex with copper at a temperature higher than ambient temperature.

In the copper particulate dispersion, the compound is preferably selected from the group consisting of alcohol, phosphate ester, carboxylic acid, polyamide, polyamideimide, polyimide, amine, phosphonic acid, β-diketone, acetylene glycol, thioether, and sulfate ester.

In the copper particulate dispersion, the sintering promoter may be an acid that dissolves copper oxide at a temperature higher than ambient temperature.

In the copper particulate dispersion, the acid is preferably acetic acid.

In the copper particulate dispersion, the sintering promoter may be an alkali that dissolves copper oxide at a temperature higher than ambient temperature.

In the copper particulate dispersion, the alkali is preferably potassium hydroxide.

The conductive film forming method according to the present invention comprises the steps of forming a coating comprising the copper particulate dispersion on a base material, and irradiating the coating with light to photo-sinter the copper particulates in the coating, thereby forming a conductive film.

In the circuit board according to the present invention, a circuit having the conductive film formed by the conductive film forming method is provided on a substrate comprising the base material.

### [Advantageous Effects of Invention]

According to the copper particulate dispersion of the present invention, a conductive film with low electric resistance can be easily formed by photo-sintering, because a sintering promoter removes surface oxide coatings from copper particulates during the photo-sintering of the copper particulates.

### [Brief Description of Drawing]

[Fig. 1]

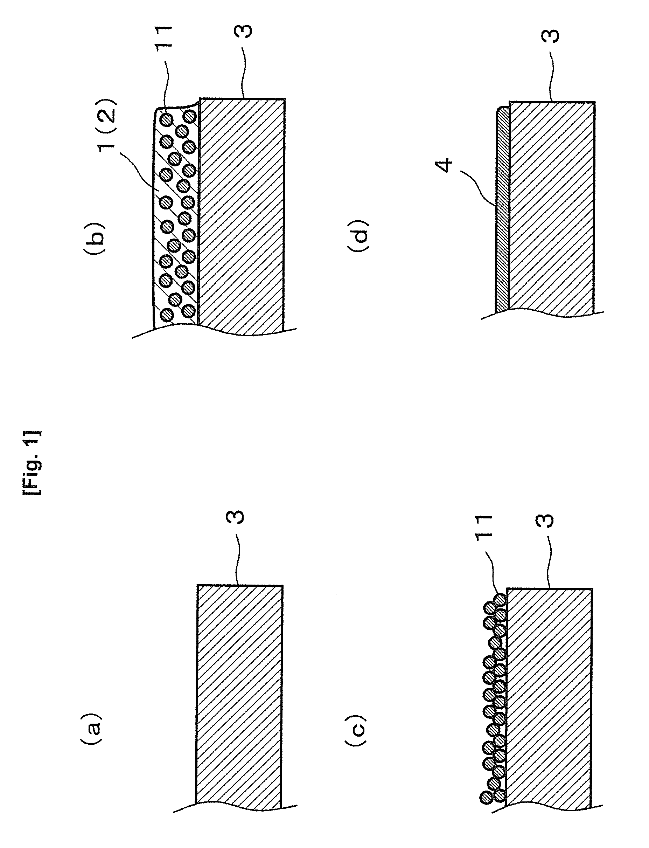

   Figs. 1 (a) to (d) are cross-sectional schematic diagrams that show the formation of a conductive film in chronological order using the copper particulate dispersion according to one embodiment of the present invention.

### [Description of Embodiments]

The copper particulate dispersion according to one embodiment of the present invention is described. The copper particulate dispersion comprises a dispersion vehicle and copper particulates. The copper particulates are dispersed in the dispersion vehicle. The copper particulate dispersion contains a sintering promoter. The sintering promoter is a compound that removes copper oxide from copper at a temperature higher than ambient temperature. The copper oxide includes copper (I) oxide and copper(II) oxide. The temperature higher than ambient temperature is obtained by irradiation with light for photo-sintering the copper particulates.

The sintering promoter is, for example, a compound that forms a complex with copper at a temperature higher than ambient temperature. Such a compound removes oxide from copper by complex formation with copper. Examples of the compound include, but are not limited to, alcohol, phosphate ester, carboxylic acid, polyamideimide, polyimide, amine, phosphonic acid, β-diketone, acetylene glycol, thioether, sulfate ester, and the like.

The sintering promoter may be an acid that dissolves copper oxide at a temperature higher than ambient temperature. Such an acid removes oxide from copper by dissolving copper oxide. The acid is, for example, acetic acid, but is not limited thereto.

The sintering promoter may be an alkali that dissolves copper oxide at a temperature higher than ambient temperature. Such an alkali removes oxide from copper by dissolving copper oxide. The alkali is, for example, potassium hydroxide, but is not limited thereto.

The sintering promoter may be a compound that removes oxide from copper by reducing copper oxide at a temperature higher than ambient temperature.

These sintering promoters may be used singly or in a mixture of two or more.

In this embodiment, the copper particulates are particles of copper having a mean particle size of about 20 nm or more and about 1,500 nm or less. The particle size of the copper particulates is not limited as long as the copper particulates are dispersed in a dispersion vehicle. Copper particulates having one mean particle size may be used alone, or copper particulates having two or more mean particle sizes may be used in mixture. The copper particulate dispersion is a liquid dispersion system in which copper particulates are dispersed in a dispersion vehicle. The dispersion vehicle is a liquid, such as alcohol, but is not limited thereto.

The sintering promoter is added, for example, to the dispersion vehicle. The sintering promoter may be added during the production of the copper particulate dispersion, or after production of the copper particulate dispersion and before use. Examples of the sintering promoter include, but are not limited to, carboxylic acid, polyamide, polyamideimide, polyimide, amine, phosphonic acid, β-diketone, acetylene glycol, thioether, sulfate ester, and the like.

In this embodiment, a dispersant is added to the dispersion vehicle. The dispersant disperses the copper particulates in the dispersion vehicle. When the copper particulates are dispersed without using a dispersant, a dispersant may not be added.

The sintering promoter may be a compound that also serves as a dispersant. Examples of such a sintering promoter include, but are not limited to, phosphate ester, and the like.

The sintering promoter may be a compound that also serves as a dispersion vehicle. Examples of such a sintering promoter include, but are not limited to, alcohols, such as diethylene glycol and diethylene glycol monoethyl ether.

A conductive film forming method using the copper particulate dispersion of this embodiment is described with reference to Figs. 1 (a) to (d). As shown in Fig. 1 (a) and Fig. 1 (b), a coating 2 comprising the copper particulate dispersion 1 is first formed on a base material 3. Copper particulates 11 are dispersed in the coating 2. The coating 2 is formed by, for example, a printing method. In the printing method, the copper particulate dispersion 1 is used as ink for printing, and a predetermined pattern is printed on an object by a printer, thereby forming the coating 2 of the pattern. The printer is, for example, a screen printer, an ink-jet printer, or the like. The coating 2 may be formed by spin coating, or the like. Examples of the base material 3 include, but are not limited to, glass, polyimide, polyethylene terephthalate (PET), polycarbonate (PC), glass epoxy, ceramic, metal, paper, and the like.

Next, the coating 2 is dried. The drying of the coating 2 is carried out at ambient temperature or by heating in a temperature range in which the sintering promoter hardly undergoes a chemical change. As shown in Fig. 1 (c), the liquid component of the coating 2 is evaporated by drying the coating 2; however, the copper particulates 11 and the sintering promoter remain in the coating 2. The drying step for drying the coating 2 may be omitted. For example, when the dispersion vehicle also serves as a sintering promoter, the drying step is omitted.

In the subsequent step, the dried coating 2 is irradiated with light. The copper particulates 11 in the coating 2 are photo-sintered by the energy of light. The copper particulates 11 are mutually fused during the photo-sintering, and welded to the base material 3. Photo-sintering is performed at room temperature in the air. The light source used for photo-sintering is, for example, a xenon lamp. The light source may instead be a laser device. The energy range of light emitted from the light source is 0.5 J/cm² or more and 30 J/cm² or less. The irradiation time is 0.1 ms or more and 100 ms or less. The irradiation frequency may be once or more than once (multi-step irradiation). Irradiation may be performed several times with different amounts of light energy. The light energy and the irradiation frequency are not limited to these values. As shown in Fig. 1 (d), due to the photo-sintering of the copper particulates 11 in the coating 2, the coating 2 is bulked to thereby form a conductive film 4. The configuration of the formed conductive film 4 is a continuous coating. When the drying of the coating 2 before irradiation with light is omitted, the coating 2 is dried by irradiation with light, while the copper particulates 11 in the coating 2 are photo-sintered.

The surface of the copper particulates 11 is oxidized by oxygen and covered with surface oxide coatings. The surface oxide coatings prevent bulking of the coating 2 comprising the copper particulate 11 during the photo-sintering. Conventionally, it is considered that the surface oxide coatings of the copper particulates 11 are reduced to metal copper by photoreduction by the energy of light during photo-sintering. However, according to the experiments conducted by the inventor of the present invention, even when the energy of light to be irradiated during photo-sintering is increased, bulking of the coating 2 may be insufficient. Moreover, when the energy of light to be irradiated is overly large, the coating 2 may be damaged; thus, there are limitations on the amount of energy of light to be irradiated during photo-sintering. The inventor of the present invention considered that photo-sintering does not sufficiently proceed because light energy alone is not sufficient to remove surface oxide coatings from the copper particulates 11, and that bulking of the coating 2 may be insufficient.

The inventor of the present invention found, by many experiments, that photo-sintering was promoted by removing surface oxide coatings from the copper particulates 11 by a chemical reaction. In this embodiment, the sintering promoter hardly undergoes a chemical reaction with the surface oxide coatings of the copper particulates 11 at a temperature before the coating 2 is irradiated with light, that is, at ambient temperature. The surface oxide coatings of the copper particulates 11 prevent oxidation of the inside of the particulates. When the coating 2 is irradiated with light for photo-sintering the copper particulates 11, the copper particulates 11 absorb the light energy to become a high temperature. The sintering promoter present in the coating 2 is heated by the high-temperature copper particulates 11 to a high temperature (a temperature higher than ambient temperature). Since the chemical reaction is promoted at a high temperature, the sintering promoter removes surface oxide coatings from the copper particulates 11 by the chemical reaction. The copper particulates 11, from which the surface oxide coatings have been removed, are sintered by the energy of light, thereby forming a conductive film 4 with low electric resistance.

As stated above, due to the use of the copper particulate dispersion 1 according to this embodiment, the sintering promoter removes surface oxide coatings from the copper particulates 11 during the photo-sintering of the copper particulates 11; thus, the conductive film 4 with low electric resistance can be easily formed by photo-sintering. Furthermore, due to the use of the copper particulate dispersion 1, the conductive film 4 with low electric resistance can be easily formed on a circuit board.

Copper particulate dispersions 1 containing a sintering promoter were prepared as Examples of the present invention, and copper particulate dispersions free from a sintering promoter were prepared as Comparative Examples. These copper particulate dispersions were used to examine whether a conductive film was formed on a substrate by photo-sintering.

### [Example 1]

A copper particulate dispersion in which a dispersant was added to disperse copper particulates in a dispersion vehicle was prepared. The dispersion vehicle was alcohol (diethylene glycol). This dispersion vehicle also served as a sintering promoter in this Example. The dispersant was phosphate ester (trade name: "DISPERBYK (registered trademark)-102," available from BYK-Chemie). The concentration of the dispersant was 2 mass% with respect to the copper particulate dispersion. The copper particulates used had a mean particle size of 50 nm, and the concentration of the copper particulates was 40 mass%. A glass slide was used as a substrate.

The copper particulate dispersion was applied to the substrate by spin-coating to form a coating with a thickness of 1 µm. The color of the coating was black. The coating was irradiated with light, without drying. The light irradiation energy was 14 J/cm².

The appearance of the coating was changed to the appearance of metal copper by light irradiation, and a conductive film was formed on the substrate. The sheet resistance of the formed conductive film was measured as the electric resistance of the film. The sheet resistance of the conductive film was as low as 480 mΩ/sq.

### [Example 2]

The dispersion vehicle used was alcohol (diethylene glycol monoethyl ether) different from that of Example 1. This dispersion vehicle also served as a sintering promoter in this Example. The dispersant used was phosphate ester (trade name: "DISPERBYK (registered trademark)-111," available from BYK-Chemie) different from that of Example 1. The other conditions were the same as those of Example 1. The appearance of the coating was changed to the appearance of metal copper by light irradiation, and a conductive film was formed on the substrate. The sheet resistance of the formed conductive film was 500 mΩ/sq.

### [Example 3]

A copper particulate dispersion was prepared using copper particulates having a mean particle size of 70 nm. Then, phosphate ester (trade name: "DISPERBYK (registered trademark)-111," available from BYK-Chemie) was added as a sintering promoter to the copper particulate dispersion. This sintering promoter also served as a dispersant. The concentration of the sintering promoter was 10 mass% with respect to the copper particulate dispersion. A glass substrate (trade name "EAGLE XG (registered trademark)," available from Corning) was used as a substrate. The other conditions were the same as those of Example 2. A coating comprising the copper particulate dispersion was formed on the substrate. After the coating was dried, the coating was irradiated with light. The light irradiation energy was 11 J/cm². The appearance of the coating was changed to the appearance of metal copper by light irradiation, and a conductive film was formed on the substrate. The sheet resistance of the formed conductive film was 170 mΩ/sq.

### [Example 4]

A copper particulate dispersion was prepared using phosphate ester (trade name: "DISPERBYK (registered trademark)-102," available from BYK-Chemie) as a dispersant. Then, carboxylic acid (trade name: "DISPERBYK (registered trademark)-P-105," available from BYK-Chemie) was added as a sintering promoter to the copper particulate dispersion. The other conditions were the same as those of Example 3. The appearance of the coating was changed to the appearance of metal copper by light irradiation, and a conductive film was formed on the substrate. The sheet resistance of the formed conductive film was 350 mΩ/sq.

### [Example 5]

After a copper particulate dispersion was prepared, polyamideimide (trade name: "SOXR-U," available from Nippon Kodoshi Corporation) was added as a sintering promoter. The other conditions were the same as those of Example 4. The appearance of the coating was changed to the appearance of metal copper by light irradiation, and a conductive film was formed on the substrate. The sheet resistance of the formed conductive film was 240 mΩ/sq.

### [Example 6]

After a copper particulate dispersion was prepared, polyimide (polyimide varnish) was added as a sintering promoter. The other conditions were the same as those of Example 5. The appearance of the coating was changed to the appearance of metal copper by light irradiation, and a conductive film was formed on the substrate. The sheet resistance of the formed conductive film was 250 mΩ/sq.

### [Example 7]

After a copper particulate dispersion was prepared, alcohol (polyethylene glycol; molecular weight: 600) was added as a sintering promoter. The other conditions were the same as those of Example 6. The appearance of the coating was changed to the appearance of metal copper by light irradiation, and a conductive film was formed on the substrate. The sheet resistance of the formed conductive film was 300 mΩ/sq.

### [Example 8]

After a copper particulate dispersion was prepared, amine (triethanolamine) was added as a sintering promoter. The other conditions were the same as those of Example 7. The appearance of the coating was changed to the appearance of metal copper by light irradiation, and a conductive film was formed on the substrate. The sheet resistance of the formed conductive film was 350 mΩ/sq.

### [Example 9]

A copper particulate dispersion was prepared using copper particulates having a mean particle size of 50 nm, and adding amine (trade name: "Discole (registered trademark) N509," available from Dai-ichi Kogyo Seiyaku Co. , Ltd.) to a dispersion vehicle as a sintering promoter. The concentration of the sintering promoter was 2 mass% with respect to the copper particulate dispersion. The substrate used was a glass slide. The other conditions were the same as those of Example 8. The appearance of the coating was changed to the appearance of metal copper by light irradiation, and a conductive film was formed on the substrate. The sheet resistance of the formed conductive film was 150 mΩ/sq.

### [Example 10]

A copper particulate dispersion was prepared using polyoxyethylene tridecyl ether phosphate ester (trade name: "Plysurf (registered trademark) A212C," available from Dai-ichi Kogyo Seiyaku Co., Ltd.) as a dispersant, and adding polyamide (polyvinylpyrrolidone; trade name: "PVP K25") to a dispersion vehicle as a sintering promoter. The concentration of the sintering promoter was 10 mass% with respect to the copper particulate dispersion. The concentration of the copper particulates was 60 mass%. The copper particulate dispersion was pasty. This copper particulate dispersion was applied to a substrate by draw-down coating to form a coating with a thickness of 2 µm. The other conditions were the same as those of Example 9. The appearance of the coating was changed to the appearance of metal copper by light irradiation, and a conductive film was formed on the substrate. The sheet resistance of the formed conductive film was 240 mΩ/sq.

### [Example 11]

A copper particulate dispersion was prepared using copper particulates having a mean particle size of 1,500 nm. The copper particulate dispersion was pasty. The light irradiation energy was 20 J/cm². The other conditions were the same as those of Example 10. The appearance of the coating was changed to the appearance of metal copper by light irradiation, and a conductive film was formed on the substrate. The sheet resistance of the formed conductive film was 150 mΩ/sq.

### [Example 12]

A copper particulate dispersion was prepared using copper particulates having a mean particle size of 20 nm, and adding polyamide (polyvinylpyrrolidone, trade name: "PVP K90") as a sintering promoter to a dispersion vehicle. The copper particulate dispersion was pasty. The light irradiation energy was 10 J/cm². The other conditions were the same as those of Example 11. The appearance of the coating was changed to the appearance of metal copper by light irradiation, and a conductive film was formed on the substrate. The sheet resistance of the formed conductive film was 250 mΩ/sq.

### [Example 13]

A copper particulate dispersion was prepared using copper particulates having a mean particle size of 1, 500 nm, and using ethylene glycol as a dispersion vehicle. The concentration of the copper particulates were 40 mass%. The concentration of the sintering promoter was 30 mass% with respect to the copper particulate dispersion. The copper particulate dispersion was pasty. The light irradiation energy was 20 J/cm². The other conditions were the same as those of Example 12. The appearance of the coating was changed to the appearance of metal copper by light irradiation, and a conductive film was formed on the substrate. The sheet resistance of the formed conductive film was 770 mΩ/sq.

### [Example 14]

A copper particulate dispersion was prepared using copper particulates having a mean particle size of 70 nm, and using N-methylpyrrolidone as a dispersion vehicle. The copper particulate dispersion was pasty. Then, polyamide (polyvinylpyrrolidone; trade name: "PVP K25") was added as a sintering promoter to the copper particulate dispersion. The concentration of the sintering promoter was 10 mass% with respect to the copper particulate dispersion. The light irradiation energy was 11 J/cm². The other conditions were the same as those of Example 13. The appearance of the coating was changed to the appearance of metal copper by light irradiation, and a conductive film was formed on the substrate. The sheet resistance of the formed conductive film was 200 mΩsq.

### [Example 15]

A copper particulate dispersion was prepared using diethylene glycol as a dispersion vehicle. Then, phosphonic acid (a 60 mass% hydroxy ethylidene diphosphonic acid aqueous solution) was added as a sintering promoter to the copper particulate dispersion. The concentration of the sintering promoter was 10 mass% with respect to the copper particulate dispersion. The other conditions were the same as those of Example 9. The appearance of the coating was changed to the appearance of metal copper by light irradiation, and a conductive film was formed on the substrate. The sheet resistance of the formed conductive film was 270 mΩ/sq.

### [Example 16]

A copper particulate dispersion was prepared using diethylene glycol monoethyl ether as a dispersion vehicle. Then, acetic acid was added to the copper particulate dispersion as a sintering promoter. The other conditions were the same as those of Example 15. The appearance of the coating was changed to the appearance of metal copper by light irradiation, and a conductive film was formed on the substrate. The sheet resistance of the formed conductive film was 240 mΩ/sq.

### [Example 17]

After a copper particulate dispersion was prepared, β-diketone (acetylacetone) was added as a sintering promoter. The other conditions were the same as those of Example 16. The appearance of the coating was changed to the appearance of metal copper by light irradiation, and a conductive film was formed on the substrate. The sheet resistance of the formed conductive film was 250 mΩ/sq.

### [Example 18]

After a copper particulate dispersion was prepared, acetylene glycol (trade name: "Surfynol (registered trademark) 420") was added as a sintering promoter. The concentration of the sintering promoter was 1 mass% with respect to the copper particulate dispersion. The other conditions were the same as those of Example 17. The appearance of the coating was changed to the appearance of metal copper by light irradiation, and a conductive film was formed on the substrate. The sheet resistance of the formed conductive film was 340 mΩ/sq.

### [Example 19]

After a copper particulate dispersion was prepared, thioether and alcohol (thiodiglycol) were added as sintering promoters. The concentration of the sintering promoters was 10 mass% with respect to the copper particulate dispersion. The other conditions were the same as those of Example 18. The appearance of the coating was changed to the appearance of metal copper by light irradiation, and a conductive film was formed on the substrate. The sheet resistance of the formed conductive film was 160 mΩ/sq.

### [Example 20]

After a copper particulate dispersion was prepared, sulfate ester (trade name: "Sundet EN") was added as a sintering promoter. The other conditions were the same as those of Example 19. The appearance of the coating was changed to the appearance of metal copper by light irradiation, and a conductive film was formed on the substrate. The sheet resistance of the formed conductive film was 200 mΩ/sq.

### [Example 21]

After a copper particulate dispersion was prepared, amine and carboxylic acid (glycine) were added as sintering promoters. The other conditions were the same as those of Example 20. The appearance of the coating was changed to the appearance of metal copper by light irradiation, and a conductive film was formed on the substrate. The sheet resistance of the formed conductive film was 180 mΩ/sq.

### [Example 22]

A copper particulate dispersion was prepared using water as a dispersion vehicle, and an alkylolammonium salt of a copolymer with acidic groups (trade name: "DISPERBYK (registered trademark)-180") as a dispersant. Then, an alkali (potassium hydroxide) was added as a sintering promoter to the copper particulate dispersion. The concentration of the sintering promoter was 1 mass% with respect to the copper particulate dispersion. The other conditions were the same as those of Example 21. The prepared copper particulate dispersion was dispersed; however, the dispersion became a blue liquid after one day, because the dissolution of the copper particulates in water proceeded. Therefore, the copper particulate dispersion was used immediately after the preparation thereof. The appearance of the coating was changed to the appearance of metal copper by light irradiation, and a conductive film was formed on the substrate. The sheet resistance of the formed conductive film was 260 mΩ/sq.

### (Comparative Example 1)

The copper particulate dispersion and substrate used were the same as those of Example 1. A coating with a thickness of 1 µm was formed on the substrate. The color of the coating was black. After the coating was dried, the coating was irradiated with light. Because the coating was dried before irradiation with light, the dispersion vehicle did not function as a sintering promoter. The light irradiation energy was the same as that of Example 1.

The color of the coating was changed to blue by light irradiation. Since this blue color was the interference color of the copper oxide coating, a conductive film was not formed on the substrate. It is considered that the coating was oxidized by reaction with oxygen in the air because the progress of the sintering of the copper particulates was insufficient.

### (Comparative Example 2)

A copper particulate dispersion was prepared using diethylene glycol dibutyl ether as a dispersion vehicle, and using copper particulates having a mean particle size of 70 nm. Neither a dispersant nor a sintering promoter was added to the dispersion vehicle. The concentration of the copper particulates was 40 mass%. The stable dispersibility of the copper particulates in this copper particulate dispersion was low. The copper particulates were dispersed for a while after stirring, but precipitated in about 1 hour. The substrate used was the same glass substrate of Example 3. A coating comprising the copper particulate dispersion was formed on the substrate. After the coating was dried, the coating was irradiated with light. The light irradiation energy was 11 J/cm². As a result of irradiation with light, the aggregated copper particulates remained on the substrate as many agglomerates. This state is called "blow-off." Although the sintering of the copper particulates proceeded to some extent, a conductive film was not formed.

### (Comparative Example 3)

N-hexane was used as a dispersion vehicle. Phosphate ester (trade name: "DISPERBYK (registered trademark) -102") was used as a dispersant. The concentration of the dispersant was 2 mass% with respect to the copper particulate dispersion. The other conditions were the same as those of Comparative Example 2. A coating comprising the copper particulate dispersion was formed on the substrate. After the coating was dried, the coating was irradiated with light. After irradiation with light, the color of the coating on the substrate was black, and the sheet resistance thereof was as high as 1 Ω/sq. When the light irradiation energy was increased to higher than 11 J/cm², the color of the coating was changed to blue, and surface oxidation of the coating occurred.

### (Comparative Example 4)

1,3-Dimethyl-2-imidazolidinone was used as a dispersion vehicle. The other conditions were the same as those of Comparative Example 3. After irradiation with light, the color of the coating on the substrate was black, and the sheet resistance thereof was 1 Ω/sq. When the light irradiation energy was increased to higher than 11 J/cm², the color of the coating was changed to blue, and surface oxidation of the coating occurred.

### (Comparative Example 5)

N-methylpyrrolidone was used as a dispersion vehicle. The other conditions were the same as those of Comparative Example 4. After irradiation with light, the color of the coating on the substrate was black, and the sheet resistance thereof was 1 Ω/sq. When the light irradiation energy was increased to higher than 11 J/cm², the color of the coating was changed to blue, and surface oxidation of the coating occurred.

### (Comparative Example 6)

Propylene carbonate was used as a dispersion vehicle. The other conditions were the same as those of Comparative Example 5. After irradiation with light, the color of the coating on the substrate was black, and the sheet resistance thereof was 1 Ω/sq. When the light irradiation energy was increased to higher than 11 J/cm², the color of the coating was changed to blue, and surface oxidation of the coating occurred.

### (Comparative Example 7)

Water was used as a dispersion vehicle. An alkylolammonium salt of a copolymer with acidic groups (trade name: "DISPERBYK (registered trademark)-180") was used as a dispersant. The other conditions were the same as those of Comparative Example 6. The prepared copper particulate dispersion became a blue liquid after one day, because the dissolution of the copper particulates in water proceeded. Therefore, the copper particulate dispersion was used immediately after the preparation thereof. After irradiation with light, the color of the coating on the substrate was black, and the sheet resistance thereof was 1 Ω/sq. When the light irradiation energy was increased to higher than 11 J/cm², the color of the coating was changed to blue, and surface oxidation of the coating occurred.

As shown in Examples 1 to 22 above, when a copper particulate dispersion that contained a sintering promoter was used, a conductive film with low electric resistance was formed on a substrate by photo-sintering. As shown in Comparative Examples 1 to 7 above, when a copper particulate dispersion that did not contain a sintering promoter was used, a conductive film with low electric resistance was not formed on a substrate.

The present invention is not limited to the configurations of the above embodiments, and various modifications can be applied within a range that does not change the subject-matter of the invention. For example, the form of the base material 3 is not limited to a plate shape, and may be any three-dimensional shape.

### [Reference Numerals and Signs]

- 1.: Copper particulate dispersion
- 11.: Copper particulates
- 2.: Coating
- 3.: Base material
- 4.: Conductive film

## Claims

1. A copper particulate dispersion comprising a dispersion vehicle and copper particulates dispersed in the dispersion vehicle, **characterized in that**:
the copper particulate dispersion contains a sintering promoter; and
the sintering promoter is a compound that removes copper oxide from copper at a temperature higher than ambient temperature.

2. The copper particulate dispersion according to claim 1, wherein the temperature higher than ambient temperature is obtained by irradiation with light for photo-sintering the copper particulates.

3. The copper particulate dispersion according to claim 1 or 2, wherein the sintering promoter is a compound that forms a complex with copper at a temperature higher than ambient temperature.

4. The copper particulate dispersion according to claim 3, wherein the compound is selected from the group consisting of alcohol, phosphate ester, carboxylic acid, polyamide, polyamideimide, polyimide, amine, phosphonic acid, β-diketone, acetylene glycol, thioether, and sulfate ester.

5. The copper particulate dispersion according to claim 1 or 2, wherein the sintering promoter is an acid that dissolves copper oxide at a temperature higher than ambient temperature.

6. The copper particulate dispersion according to claim 5, wherein the acid is acetic acid.

7. The copper particulate dispersion according to claim 1 or 2, wherein the sintering promoter is an alkali that dissolves copper oxide at a temperature higher than ambient temperature.

8. The copper particulate dispersion according to claim 7, wherein the alkali is potassium hydroxide.

9. A conductive film forming method **characterized by** comprising the steps of:
forming a coating comprising the copper particulate dispersion according to any one of claims 1 to 8 on a base material; and
irradiating the coating with light to photo-sinter the copper particulates in the coating, thereby forming a conductive film.

10. A circuit board in which a circuit having the conductive film formed by the conductive film forming method according to claim 9 is provided on a substrate comprising the base material.

## Amended claims

### Amended claims under Art. 19.1 PCT

**1.** (Amended) A copper particulate dispersion comprising a dispersion vehicle and copper particulates dispersed in the dispersion vehicle, **characterized in that**:
the copper particulate dispersion contains a sintering promoter; and
the sintering promoter is a compound that removes copper oxide from copper at a temperature higher than ambient temperature, and it is a compound that forms a complex with copper at a temperature higher than ambient temperature, and it is selected from the group consisting of polyamide, polyamideimide, polyimide, phosphonic acid, β-diketone, acetylene glycol, thioether, and sulfate ester.

**2.** (Amended) A copper particulate dispersion comprising a dispersion vehicle and copper particulates dispersed in the dispersion vehicle, **characterized in that**:
the copper particulate dispersion contains a sintering promoter; and
the sintering promoter is a compound that removes copper oxide from copper at a temperature higher than ambient temperature, and it is an alkali that dissolves copper oxide at a temperature higher than ambient temperature, and the alkali is potassium hydroxide.

**3.** (Amended) The copper particulate dispersion according to claim 1 or claim 2, wherein the temperature higher than ambient temperature is obtained by irradiation with light for photo-sintering the copper particulates.

**4.** (Canceled)

**5.** (Canceled)

**6.** (Canceled)

**7.** (Canceled)

**8.** (Canceled)

**9.** (Amended) A conductive film forming method **characterized by** comprising the steps of:
forming a coating comprising the copper particulate dispersion according to claim 1 or claim 2 on a base material; and
irradiating the coating with light to photo-sinter the copper particulates in the coating, thereby forming a conductive film.

**10.** A circuit board in which a circuit having the conductive film formed by the conductive film forming method according to claim 9 is provided on a substrate comprising the base material.

Statement under Art. 19.1 PCT
In Claim 1, the copper particulate dispersion contains a compound selected from the group consisting of polyamide, polyamideimide, polyimide, phosphonic acid, β-diketone, acetylene glycol, thioether, and sulfate ester.

In Claim 2, the copper particulate dispersion contains potassium hydroxide. It is not described in the cited reference that the above-described compound is contained in the copper particulate dispersion.

The present invention achieves an effect that by containing the above-described compound in the copper particulate dispersion, the photo-sintering of the copper particulates is promoted and a conductive film with low electric resistance can be formed.
